(19) Europäisches Patentamt
European Patent Office
Office européen des brevets

(11) **EP 2 284 213 A1**

(12) **EUROPEAN PATENT APPLICATION**
published in accordance with Art. 153(4) EPC

(43) Date of publication:
**16.02.2011 Bulletin 2011/07**

(51) Int Cl.:
*C08J 5/18* (2006.01)    *B32B 27/30* (2006.01)
*H01L 31/04* (2006.01)

(21) Application number: **09750621.6**

(22) Date of filing: **21.05.2009**

(86) International application number:
**PCT/JP2009/059329**

(87) International publication number:
**WO 2009/142259 (26.11.2009 Gazette 2009/48)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **22.05.2008 JP 2008134260**

(71) Applicant: **Daikin Industries, Ltd.**
**Osaka 530-8323 (JP)**

(72) Inventors:
• **OZAKI Hidenori**
**Settsu-shi**
**Osaka 566-8585 (JP)**

• **KAWASAKI Kenji**
**Settsu-shi**
**Osaka 566-8585 (JP)**
• **HIGUCHI Tatsuya**
**Settsu-shi**
**Osaka 566-8585 (JP)**
• **ARAKI Takayuki**
**Settsu-shi**
**Osaka 566-8585 (JP)**

(74) Representative: **HOFFMANN EITLE**
**Patent- und Rechtsanwälte**
**Arabellastraße 4**
**81925 München (DE)**

(54) **POLYCHLOROTRIFLUOROETHYLENE FILM AND BACKSIDE PROTECTIVE SHEET FOR SOLAR CELL**

(57) The present invention provides a polychlorotrifluoroethylene film having ultraviolet shielding ability, moisture resistance and small absolute values of thermal deformation rates. The present invention is a polychlorotrifluoroethylene film having an ultraviolet shield rate of not lower than 70%, a water vapor transmission rate of not higher than 1.00 g/m²·day and absolute values of thermal deformation rates after 30 minutes-heating at 150°C of not higher than 5.0%.

EP 2 284 213 A1

**Description**

TECHNICAL FIELD

The present invention relates to a polychlorotrifluoroethylene film and a backsheet for a solar cell module utilizing the same.

BACKGROUND ART

In the art, a solar cell module, which is to be installed outdoors, is required to be resistant to weathering and moisture, among others and, therefore, vinyl fluoride-, vinylidene fluoride- or ethylene/tetrafluoroethylene-based or like fluororesin films have been mainly used as or in a backsheet (backside protective sheet). For improving the moisture resistance, in particular, use is currently made of a laminate composed of such a film and an aluminum foil or a polyethylene terephthalate [PET] layer with an inorganic layer vapor-deposited thereon. However, the laminate with an aluminum foil enhances the possibility of electrical short-circuiting and also have problems such as the increased production cost problem, whereas the laminate with a PET layer with an inorganic layer vapor-deposited thereon are subject to degradation, by hydrolysis, of the PET layer under high-temperature high-humidity circumstances; thus, they have the problem of the moisture resistance diminishing over time as a result of partial destruction of the vapor-deposited layer as caused by such PET layer degradation. As a means for solving those problems, the use has been proposed of polychlorotrifluoroethylene [PCTFE] excellent in weathering resistance, moisture resistance and hydrolysis resistance (cf. e.g. Patent Document 1).

PRIOR ART DOCUMENT

PATENT DOCUMENT

Patent Document 1: Japanese Kokai Publication 2001-127320

SUMMARY OF THE INVENTION

PROBLEMS WHICH THE INVENTION IS TO SOLVE

However, when, for example, a PET/PCTFE film laminate is constituted through the intermediary of an adhesive, there arise problems; namely, degradation of an adhesive layer occurs due to invasion of ultraviolet rays, causing peeling and/or swelling. In this case, the PET layer is also subject to degradation. Further, the conventional PCTFE, film shows high thermal deformation rates and, under high-temperature high-humidity circumstances, the deformation raises the problems of peeling, swelling and crack formation.

There have been no conventional backsheets in which use is made of a PCTFE film having a sufficient level of ultraviolet shielding ability and at the same time excellent in moisture resistance and having low absolute values of thermal deformation rates. In view of the above-discussed state of the art, it is an object of the present invention to provide a PCTFE, film which has both ultraviolet shielding ability and moisture resistance, together with low thermal deformation rates.

MEANS FOR SOLVING THE PROBLEMS

The present invention is a polychlorotrifluoroethylene [PCTFE] film having an ultraviolet shield rate of not lower than 70%, a water vapor transmission rate of not higher than 1.00 g/m$^2$· day and absolute values of thermal deformation rates after 30 minutes-heating at 150°C of not higher than 5.0%.

The invention also relates to a laminate comprising the above-mentioned PCTFE film and a resin sheet different from the PCTFE film.

The invention further relates to a backsheet for a solar cell module comprising the PCTFE film or laminate defined above.

Hereinafter, the present invention is described in detail.

The polychlorotrifluoroethylene [PCTFE] film according to the invention has an ultraviolet shield rate of not lower than 70%, a water vapor transmission rate of not higher than 1.00 g/m$^2$ · day and absolute values of thermal deformation rates after 30 minutes of heating at 150°C of not higher than 5.0%.

The PCTFE film according to the invention has an ultraviolet shield rate of not lower than 70%. At ultraviolet shield rate levels lower than 70%, an adhesive and resin layer cannot be inhibited satisfactorily from being deteriorated by ultraviolet rays and, if the PCTFE film according to the invention has such a low ultraviolet shield rate and is used as the backsheet for a solar cell module, in particular, the ultraviolet degradation of the solar cell module constituent adhesive layer will become significant. The above ultraviolet shield rate is preferably not lower than 95%.

For providing a fluororesin with ultraviolet shielding ability, the use has so far been made of an organic ultraviolet absorber such as a benzophenone compound and a benzotriazole compound, and an inorganic ultraviolet absorber such as titanium oxide and zinc oxide. However, as a result of intensive investigations made by the present inventors in search of a means for improving the ultraviolet shield rates shown by PCTFE films, it was found that melt-kneading of those ultraviolet absorbers with PCTFE results in decomposition of PCTFE, which produces such problems as foaming, discoloration and viscosity decreases, and that carbon black alone can be melt-kneaded with PCTFE.

Thus, the above-mentioned levels of ultraviolet shield rate can be attained by the addition of carbon black of all known ultraviolet absorbers. For such reason, the PCTFE film according to the invention preferably has a black color.

Furthermore, the PCTFE, film according to the invention shows a water vapor transmission rate of not higher than 1.00 g/m$^2$ · day. If the PCTFE film according to the invention shows a water vapor transmission rate higher than 1.00 g/m$^2$·day and is used as the backsheet for a solar cell module, markedly decreased power efficiency will result. The above water vapor transmission rate is preferably not higher than 0.50 g/cm$^2$·day.

It is generally considered that the admixture of such a filler as carbon black with a fluororesin will result in an increase in the water vapor transmission rate of the fluororesin. Therefore, it is very difficult to maintain the moisture resistance while raising the ultraviolet shield rate. However, by selecting the ultraviolet absorber addition level within a very limited range, it becomes possible to attain the above-mentioned ultraviolet shield rate without lowering the moisture resistance.

Thus, by selecting carbon black as the ultraviolet absorber and adding carbon black to PCTFE at an addition level within a very limited range of 0.2 to 4.0% by mass, it becomes possible to realize both the above-mentioned respective ranges of ultraviolet shield rate and water vapor transmission rate. Carbon black addition levels lower than 0.2% by mass will possibly lead to failure to obtain sufficient ultraviolet shield rates, and carbon black addition levels exceeding 4.0% by mass may possibly lead to decreases in moisture resistance. The carbon black addition level is more preferably not lower than 0.3% by mass, but more preferably not higher than 2.0% by mass.

The ultraviolet shield rate so referred to herein is the value obtained by measuring the transmittance (%) at the wavelength 360 nm on a Hitachi model U-4100 spectrophotometer and making a calculation as follows: Ultraviolet shield rate (%) = 100 - transmittance (%)

The water vapor transmission rate so referred to herein is the value obtained by subjecting a film to the transmission testing according to JIS K 7129 (Method B) under conditions of 40°C and 90% humidity using PERMATRAN-W3/31 (product of MOCON, Inc.).

The above-mentioned carbon black is not particularly restricted in kind but may be, for example, acetylene black, furnace black or Ketjen black.

The addition of the carbon black mentioned above can be achieved, for example, by melt-kneading the PCTFE resin and carbon black at 250 to 320°C.

The PCTFE film according to the invention can also be obtained by adding at least one metal oxide selected from the group consisting of titanium oxide and zinc oxide to the PCTFE. For such reason, the PCTFE film according to the invention preferably has a white color.

The addition of an ultraviolet absorber other than carbon black to PCTFE causes degradation of PCTFE and thus produces such problems as foaming, discoloration and viscosity decreases, as mentioned above. The present inventors made extensive investigations to find out a method of producing a white PCTFE, film and, as a result, found that the use of ETFE, FEP or a like resin other than PCTFE in combination with PCTFE makes it possible to produce a titanium oxide- or zinc oxide-containing PCTFE film having both ultraviolet shielding ability and moisture resistance.

The level of addition of at least one metal oxide selected from the group consisting of titanium oxide and zinc oxide is preferably 1.0 to 15.0% by mass relative to the film. Excessively higher metal oxide contents may result in insufficient dispersion in the step of melt kneading, possibly making the film obtained inferior in physical characteristics. At excessively low metal oxide contents, the ultraviolet shield rate will possibly fail to arrive at a desired high level.

Zinc oxide is preferred as the metal oxide mentioned above. Even at relatively high addition levels, zinc oxide will not cause foaming. On the other hand, titanium oxide, when present at high addition levels, causes foaming on the occasion of molding a film, so that foaming-due linear molding streaks are observed in the appearance of the film obtained.

The metal oxide mentioned above preferably has an average particle diameter of 0.4 to 1.0 $\mu$m. If the average particle size is excessively smaller, foaming may occur in the step of molding and, if the average particle size is excessively greater, the dispersibility and/or moldability will possibly become poor. The average particle diameter can be measured by using a transmission electron microscope.

The PCTFE film according to the invention shows absolute values of thermal deformation rates of not higher than 5.0% after 30 minutes of heating at 150°C. When the above-mentioned absolute values of thermal deformation rates are in excess of 5.0%, shrinkage stress-due peeling, swelling and/or crack formation will occur under high-temperature high-humidity circumstances. The absolute values of thermal deformation rates are preferably not higher than 2.0%.

It has so far been thought that since the possible molding temperature range for PCTFE is close to the decomposition temperature of PCTFE, the molding temperature thereof cannot be raised too much. Further, the molding of PCTFE at high temperatures tends to cause decomposition thereof, leading to reductions in mechanical characteristics. Contrary to such technological common sense, the present inventors found that a black PCTFE film obtained by molding at a temperature within a specific range, even at a high temperature, can show lowered absolute values of thermal deformation rates while maintaining the mechanical characteristics and moisture resistance.

Thus, by molding PCTFE and carbon black into a black film at a molding temperature of 320 to 360°C, it becomes possible to realize both the above-mentioned respective levels of water vapor transmission rate and thermal deformation rates. Molding temperatures lower than 320°C cause increases in the absolute values of thermal deformation rates, whereas temperatures higher than 360°C cause deteriorations in mechanical characteristics and may also cause decreases in moisture resistance. In cases where the above-mentioned PCTFE film does not contain any of the fluororesins other than PCTFE which are to be mentioned later herein, the above molding temperature is more preferably not lower than 330°C but not higher than 350°C. In a case of molding using an extruder, the molding temperature mentioned above refers to the extruder die temperature.

The thermal deformation rates so referred to herein are obtained in the following manner. Thus, a cutout film sample, 50 mm x 50 mm in size, is allowed to stand in an electric oven maintained at 150°C for 30 minutes. Before and after heating, the lengths in a direction of extrudate flow (machine direction; MD) and in a direction (transverse direction; TD) perpendicular to the direction of extrudate flow, respectively, are measured. Then, the thermal deformation rate is calculated as follows; Thermal deformation rate = {(length after heating) - (length before heating)} ÷ (length before heating) x 100

The phrase "absolute values of thermal deformation rates of not higher than 5.0%", as used herein means that each of the TD and MD thermal deformation rates, as expressed in terms of absolute value, is not higher than 5.0%.

The above-mentioned PCTFE may be either a homopolymer in which the monomer units are exclusively chlorotrifluoroethylene [CTFE,] units, or a copolymer of CTFE and a monomer copolymerizable with CTFE provided that the CTFE unit content is not lower than 90 mole percent.

The CTFE unit so referred to herein is a CTFE-derived moiety [-CFCl-CF$_2$-] of a molecular structure of PCTFE.

The above-mentioned CTFE unit content is a value obtained by some analytical techniques including $^{19}$F-NMR spectrometry and, more specifically, is the value obtained by NMR analysis, infrared spectroscopic analysis [IR] and elemental analysis, used in appropriate combination according to the monomer species.

The above-mentioned monomer copolymerizable with CTFE is not particularly restricted but may be any one copolymerizable with CTFE and may be a combination of two or more species; thus, mention may be made of ethylene [Et], tetrafluoroethylene [TFE], vinylidene fluoride [VdF], a perfluoro(alkyl vinyl ether) [PAVE] species, a vinyl monomer represented by the general formula (I):

$$CX^3X^4=CX^1(CF_2)_nX^2 \qquad (I)$$

wherein $X^1$, $X^3$ and $X^4$ may be the same or different and each represents H, F or $CF_3$, $X^2$ represents a hydrogen, fluorine or chlorine atom and n represents an integer of 1 to 10, an alkyl perfluorovinyl ether derivative represented by the general formula (II):

$$CF_2=CF-OCH_2-Rf^1 \qquad (II)$$

wherein $Rf^1$ represents a perfluoroalkyl group containing 1 to 5 carbon atoms, an acrylic compound represented by the general formula (III):

$$CH_2=CH-COOR \qquad (III)$$

wherein R represents a straight or branched hydrocarbon group containing 1 to 20 carbon atoms or a hydrogen atom, and a compound represented by the general formula (IV):

$$CX^5X^6=CF(CF_2)_a-O-Rf^2-Z \qquad (IV)$$

wherein $X^5$ and $X^6$ may be the same or different and each represents H or F, a is 0 or 1, $Rf^2$ is a fluorine-containing alkylene group containing 1 to 20 carbon atoms, which may optionally contain one or more ether bonds, and Z represents a functional group selected from the group consisting of -OH, -CH$_2$OH, -COOM (in which M represents H or an alkali metal), a carboxyl group-derived group, -SO$_3$M (in which M represents H or an alkali metal), a sulfonic acid-derived group, an epoxy group, -CN, -I and -Br.

The above-mentioned monomer preferably comprises at least one member selected from the group consisting of Et, TFE, VdF, PAVEs and vinyl monomers represented by the general formula (I) given hereinabove.

Preferred as the above-mentioned PAVE is a perfluoro(alkyl vinyl ether) species represented by the general formula (V):

$$CF_2=CF-ORf^3 \qquad (V)$$

wherein Rf$^3$ represents a perfluoroalkyl group containing 1 to 8 carbon atoms.

As the perfluoro(alkyl vinyl ether) species represented by the above general formula (V), there may specifically be mentioned perfluoro(methyl vinyl ether), perfluoro(ethyl vinyl ether), perfluoro(propyl vinyl ether) and perfluoro(butyl vinyl ether), among others. Among them, perfluoro(methyl vinyl ether), perfluoro(ethyl vinyl ether) and perfluoro(propyl vinyl ether) are preferred.

The vinyl monomer represented by the above general formula (I) is not particularly restricted but includes, among others, hexafluoropropylene [HFP],
perfluoro(1,1,2-trihydro-1-hexene),
perfluoro(1,1,5-trihydro-l-pentene) and
perfluoro(alkyl)ethylene species represented by the general formula (VI):

$$H_2C-CX^7-Rf^4 \qquad (VI)$$

wherein X$^7$ is H, F or CF$_3$ and Rf$^4$ is a perfluoroalkyl group containing 1 to 10 carbon atoms.

Perfluoro(butyl)ethylene is a preferred perfluoro(alkyl)ethylene.

Preferred as the above-mentioned alKyl perfluorovinyl ether derivatives represented by the general formula (II) are those in which Rf$^1$ is a perfluoroalkyl group containing 1 to 3 carbon atoms; CF$_2$=CF-OCH$_2$-CF$_2$CF$_3$ is more preferred.

Referring to the above general formula (III), R is preferably an alkyl group containing 1 to 20 carbon atoms or a cycloalkyl group containing 4 to 20 carbon atoms.

The group R mentioned above may be one containing at least one heteroatom such as Cl, O or N and, further, may contain a functional group such as -OH, -COOH, an epoxide, ester or ether moiety, or a double bond.

As the carboxyl group-derived group represented by Z in the above general formula (IV), there may be mentioned, for example, groups represented by the general formula: -C(=O)Q$^1$ wherein Q$^1$ represents -OR$^2$ (in which R$^2$ represents an alkyl group containing 1 to 20 carbon atoms or an aryl group containing 6 to 22 carbon atoms), -NH$_2$, F, Cl, Br or I.

As the sulfonic acid-derived group represented by Z in the above general formula (IV), there may be mentioned, for example, groups represented by the general formula: -SO$_2$Q$^2$ in which Q$^2$ represents -OR$^3$ (in which R$^3$ represents an alkyl group containing 1 to 20 carbon atoms or an aryl group containing 6 to 22 carbon atoms), -NH$_2$, F, Cl, Br or I .

The above-mentioned moiety Z is preferably -COOH, -CH$_2$OH, -SO$_3$H, -SO$_3$Na, -SO$_2$F or -CN.

As specific compounds represented by the above general formula (IV), there may be mentioned, for example,
CH$_2$=CFCF$_2$O- {CF(CF$_3$) CF$_2$O}$_{n1}$-CF(CF$_3$)-Z,
CF$_2$=CFO-{CF$_2$CF(CF$_3$)O}$_{n1}$-CF$_2$CF$_2$-Z and
CF$_2$=CFO-{CF$_2$CF$_2$}$_{n1}$-Z
wherein, in the above formulas, Z is as defined above and n$^1$ represents an integer of 1 to 10.

The above-mentioned PCTFE preferably has a melting point [Tm] of 150 to 280°C.

A more preferred lower limit to the above-mentioned melting point [Tm] is 160°C, a still more preferred lower limit thereto is 70°C, and a more preferred upper limit thereto is 270°C.

The melting point so referred to hereinabove is the temperature corresponding to the peak of an endothermic curve obtained by raising the temperature at a rate of 10°C/minute according to ASTM D 4591 using a differential scanning calorimeter [DSC].

The above-mentioned PCTFE preferably has a flow value of 1 x 10$^{-4}$ to 5 x 10$^{-1}$ cm$^3$/sec. When the flow value is within the above range, good mechanical characteristics are obtained together with good moldability.

A more preferred lower limit to the above-mentioned flow value is 1 x 10$^{-3}$ cm$^3$/sec, and a more preferred upper limit thereto is 2.5 x 10$^{-1}$ cm$^3$/sec.

The flow value so referred to herein is determined by extruding the sample resin through an orifice having a diameter of 1 mm and a length of 1 mm at a temperature of 230°C under a load of 100 kgf using a model CFT-500C flow tester (product of Shimadzu Corporation), and measuring the volume of the resin extruded per second.

The PCTFE film according to the invention may comprise a fluororesin other than PCTFE. The occurrence, in the PCTFE film, of the fluororesin other than PCTFE (such resin is hereinafter sometimes referred to as "fluororesin'" for short) can reduce the absolute values of thermal deformation rates while maintaining the moisture resistance.

In the PCTFE film according to the invention, the above-mentioned fluororesin (excluding PCTFE) preferably accounts for 2 to 50% by mass relative to the total mass of the PCTFE and fluororesin since the required moldability, the moisture resistance and the low absolute values of thermal deformation rates can then be attained simultaneously. The fluororesin content is more preferably not lower than 5% by mass but more preferably not higher than 20% by mass.

The fluororesin mentioned above comprises a total of 90 to 100 mole percent of monomer units derived from at least one monomer selected from the group consisting of tetrafluoroethylene [TFE], ethylene [Et], vinylidene fluoride [VdF], hexafluoropropylene [HEP] and perfluoro(alkyl vinyl ether) [PAVE] species; hence, it is different from the above-mentioned PCTFE.

The monomer unit so referred to herein is a single monomer-derived constituent moiety in the fluoropolymer chain constituting the fluororesin. The above-mentioned content of the monomer unit is the value obtained by carrying out NMR analysis, infrared spectroscopic analysis and elemental analysis.

The fluororesin mentioned above may also be one containing monomer units different in kind from the above-mentioned monomer units provided that the fluoromonomer-derived monomer unit content is at least 40 mole percent.

As such monomer units, there may be mentioned, for example, those derived from the above-mentioned monomers copolymerizable with CTFE, the PCTFE unit, and those derived from compounds represented by the general formula (VII):

$$CX^8X^9=CX^{10} (CX^{11}CX^{12})_b(C=O)_c(O)_d\text{-Rf}^5 \qquad (VII)$$

wherein $X^8$ and $X^9$ each is H or F, $X^{10}$ is H, F, $CH_3$ or $CF_3$, $X^{11}$ and $X^{12}$ each is H, F or $CF_3$, b is an integer of 0 to 3, c and d each is 0 or 1 and $Rf^5$ is a fluorine-containing alkyl group containing 1 to 20 carbon atoms, which may optionally contain one or more ether bonds; among them, those derived from perfluoro(1,1,1-trihydrohexene), perfluoro(1,1,5-trlhydro-1-pentene) and CTFE, respectively, are preferred.

When the above fluororesin contains CTFE-derived monomer units, it is different from the above-mentioned PCTFE in that the CTFE unit content is not higher than 10 mole percent.

As the above fluororesin, there may be mentioned, for example, a tetrafluoroethylene [TFE]/ethylene [Et]/hexafluoropropylene [HFP] copolymer, poly(vinylidene fluoride) [PVdF], a TFE/Et copolymer [ETFE], poly(vinyl fluoride) [PVF], a TFE/HFP copolymer [FEP], a tetrafluoroethylene/perfluoro(methyl vinyl ether) copolymer [MFA], and a TFE/vinylidene fluoride [VdF] copolymer.

In the PCTFE film according to the invention, there may be incorporated only one species among the fluororesins mentioned above or two or more species among them.

ETFE or FEP is preferred as the above-mentioned fluororesin from the viewpoint that the absolute values of thermal deformation rates of the PCTFE film can be markedly lowered, and FEP is more preferred since it can inhibit film discoloration.

For providing the film with adhesiveness, the above fluororesin is preferably PVdF or a TFE/Et/HFP copolymer. FEP or MFA is also preferred in view of the fact that the flame retardancy of PCTFE is not reduced and because of excellent heat resistance.

From the viewpoint of moldability and of mechanical strength of the molded product obtained, the above-mentioned fluororesin is preferably a non-perhalo polymer and more preferably comprises at least one species selected from the group consisting of TFE/Et/HFP copolymers, PVdF and ETFE.

The TFE/Et/HFP copolymer preferably has the following composition: 35 to 60 mole percent of TFE, 24 to 55 mole percent of Et and 5 to 30 mole percent of HFP. The TFE/Et/HFP copolymer may be one obtained by copolymerization of a modifier monomer. The modifier monomer is not particularly restricted but includes, among others, a fluorovinyl compound represented by the general formula (VIII):

$$H_2C=CF\text{-Rf}^6 \qquad (VIII)$$

wherein $Rf^6$ is a fluoroalkyl group containing 2 to 10 carbon atoms.

From the heat resistance viewpoint, the group $Rf^6$ mentioned above is preferably a perfluoroalkyl group, an $\omega$-hydrofluoroalkyl group or an $\omega$-chloroperfluoroalkyl group.

Preferred as the above-mentioned fluorovinyl compound from the viewpoint of copolymerizability and/or cost, among others, are fluorovinyl compounds represented by the general formula (IX):

$$H_2C=CF(CF_2)_{n2}H \qquad (IX)$$

wherein $n^2$ is a number of 2 to 10; among them, those in which n = 3 to 5 are preferred.

When the TFE/Et/HFP copolymer contains modifier monomer-derived monomer units, the modifier monomer content is preferably not higher than 10 mole percent.

The PVdF mentioned above may be one obtained by copolymerization of a monomer other than VdF provided that the content of that monomer is not higher than 10 mole percent. As such monomer, there may be mentioned, for example, TFE, HFP, CTFE, $CF_2$=CFH and a PAVE.

The fluororesin other than PCTFE preferably has a melting point of 80 to 290°C.

A preferred lower limit to the above melting point is 120°C, a more preferred lower limit thereto is 140°C, a still more preferred lower limit thereto is 160°C, and a preferred upper limit thereto is 260°C. From the improved moldability viewpoint, the melting point of the above-mentioned fluororesin is more preferably lower than the melting point of the above-mentioned PCTFE.

The above-mentioned melting point is the value measured by the same method as in the case of the above-mentioned PCTFE.

The above-mentioned fluororesin may be one having at least one terminal polar group such as a carbonate group or -COOH. The carbonate group can be introduced, for example, by using a peroxycarbonate as a polymerization initiator on the occasion of producing the fluororesin by polymerization.

From the moldability viewpoint, the above-mentioned fluororesin preferably has a melt viscosity of $1 \times 10^2$ to $1 \times 10^5$ Pa · s at a temperature higher by 50°C than the melting point.

A more preferred lower limit to the above melt viscosity is $2 \times 10^2$ Pa·s, a still more preferred lower limit thereto is $4 \times 10^2$ Pa·s, a more preferred upper limit thereto is $9 \times 10^4$ Pa·s, and a still more preferred upper limit thereto is $8 \times 10^4$ Pa·s.

From the moldability viewpoint, the melt viscosity of the fluororesin is particularly preferably lower than the melt viscosity of the above-mentioned PCTFE.

The above melt viscosity is determined by extruding the sample resin through an orifice having a diameter of 2.1 mm and a length of 8 mm at a temperature higher by 50°C than that of the melting point under a load of 7 kgf using a model CFT-500C flow tester (product of Shimadzu Corporation), and making a calculation based on the rate of extrusion attained on that occasion.

From the moldability viewpoint, the above fluororesin preferably has a MFR of 0.1 to 150 (g/10 minutes A more preferred lower limit to the above MFR is 0.5 (g/10 minutes), and a more preferred upper limit thereto is 100 (g/10 minutes).

The above MFR is determined in accordance withASTM D 1238, namely by extruding the sample resin through an orifice having a diameter of 2 mm and a length of 8 mm under a load of 5 kgf using a DYNISCO melt flow index tester (product of Yasuda Seiki Seisakusho Ltd.) and measuring the weight of the resin extruded per 10 minutes.

The PCTFE and the fluororesin to be used in the practice of the invention can be respectively prepared by carrying out polymerization by a conventional method, for example by solution polymerization, emulsion polymerization or bulk polymerization, followed by dilution, concentration, coagulation and/or a like after-treatment according to need. The PCTFE is preferably prepared by carrying out suspension polymerization among others.

The polymerization conditions in the above-mentioned preparation can be properly selected according to the monomer and the polymerization initiator species employed and the amounts thereof as well as the desired product composition. Generally, however, the polymerization is carried out at a temperature of 0 to 100°C and a pressure within the range of 0 to 9.8 MPaG.

In the above polymerization, a chain transfer agent or a like additive or additives can be used according to need. The polymerization initiator and the chain transfer agent or a like additive or additives to be used may be those known in the art. The after-treatment in the above-mentioned preparation is not particularly restricted but may be carried out in the conventional manner.

The method of mixing up PCTFE and a fluororesin is not particularly restricted but mention may be made of, for example, (i) the method comprising mixing up both the polymers each in powder form, (ii) the method comprising mixing up both the polymers each in dispersion form and subjecting the resulting mixture to cocoagulation, and (iii) the method comprising adding the fluororesin to a polymerization system for producing PCTFE and carrying out the polymerization.

As for the method of further adding such an ultraviolet absorber as carbon black, titanium oxide or zinc oxide, there may be mentioned, among others, (1) the method comprising admixing the ultraviolet absorber with the powder obtained by any of the above-mentioned methods (i) to (iii), followed by melt extrusion, (2) the method comprising mixing either one of the PCTFE and the fluororesin, in pellet form, with a mixture of the other and the ultraviolet absorber, in powder form, melt kneading the resulting mixture under application of a shearing force and extruding the mixture, and (3) the method comprising mixing PCTFE pellets with fluororesin pellets prepared in admixture with the ultraviolet absorber, melt kneading the resulting mixture under application of a shearing force and extruding the mixture.

In each of the above-mentioned methods, the conditions in the kneading, melt-extrusion and other steps can be properly selected according to the PCTFE and fluororesin species employed and the amounts thereof. Generally, the kneading and melt-extrusion are preferably carried out at a temperature of 200 to 350°C. The shearing force required on the occasion of kneading can be applied by using any of various apparatus known in the art, for example a mixer or a kneader, without any particular limitation.

The PCTFE film according to the invention may be one containing one or more of such an additive as a filler, a pigment, a conductive material, a heat stabilizer and a reinforcement within an addition level range within which the properties and moldability of PCTFE will not be impaired.

As the conductive material, there may be mentioned, among others, a carbon fibril described in United States Patent No. 4,663,230 and Japanese Kokai Publication H03-174018, for instance. The above-mentioned filler and other additives are preferably added within an addition level range within which the properties of CTFE copolymers will not be impaired.

The PCTFE film according to the invention can be produced by any of molding methods known in the art, for example by extrusion molding, compression molding or injection molding. While the molding condition can be properly selected according to the fluororesin species selected and the shape of the desired molded product, among others, the molding is preferably carried out at a molding temperature within the range of 200 to 360°C.

The PCTFE film according to the invention preferably has a thickness of 12 to 60 $\mu$m.

The present invention also relates to a laminate comprising the PCTFE film according to the invention and a resin sheet different from the PCTFE film.

A resin which constitutes the resin sheet mentioned above is preferably a thermostable resin. The thermostable resin may be a fluororesin or a fluorine-free resin. The fluororesin includes, among others, PFA, a CTFE-based copolymer such as ECTFE, FEP, PVDF, ETFE and MFA. The fluorine-free resin includes polyethylene terephthalate, polybutylene terephthalate and polyethylene naphthalate, among others. The laminate mentioned above can be produced, for example, by the method comprising joining the resin sheet and the PCTFE film according to the invention together by means of an adhesive or a pressure-sensitive adhesive, the method comprising laminating in the manner of extrusion lamination, and the method comprising laminating in the manner of coextrusion molding.

The PCTFE film according to the invention and the laminate according to the invention are suited for use as the backsheet for a solar cell module, in particular. The backsheet for a solar cell module comprising the PCTFE film according to the invention or the laminate according to the invention also constitutes an aspect of the present invention.

The PCTFE film according to the invention can also be used, for example, as a fluid transfer, moisture resistant film or sheet, lining material, covering material, or slider; it can suitably be used as a moisture resistant film or sheet, among others.

The PCTFE film according to the invention, when used as a moisture resistant film or sheet, can serve, for example, as a food packaging film, drug packaging film, EL element covering film, liquid crystal sealing film, or solar cell module protecting film, as a covering material for other electric parts, electronic parts, medical materials, etc., as a film for an agricultural use, as a weather-resistant covering material for various roofing materials, side walls, etc., or as a material for a gas bag.

In a mode of practice of the present invention, the PCTFE film comprises PCTFE and carbon black. Furthermore, the film preferably comprises at least one fluororesin (exclusive of PCTFE) selected from the group consisting of ETFE and FEP species. The fluororesin (exclusive of PCTFE) preferably amounts to 2 to 50% by mass relative to the total mass of the PCTFE and fluororesin (exclusive of PCTFE). The film preferably contains the carbon black mentioned above in an amount of 0.2 to 4.0% by mass relative to the PCTFE.

As for the method of producing the PCTFE film according to the invention, the following methods may be mentioned, among others:

A method comprising mixing up PCTFE and carbon black to obtain a masterbatch, then mixing up PCTFE and the masterbatch, and molding the resulting mixture at 330°C or above;

A method comprising mixing up at least one fluororesin species selected from the group consisting of ETFE and FEP species and carbon black to obtain a masterbatch, then mixing up PCTFE and the masterbatch, and molding the resulting mixture into a film; and

A method comprising mixing up PCTFE, carbon black and at least one fluororesin species selected from the group consisting of ETFE and FEP species and molding the resulting mixture into a films.

In a further mode of practice of the invention, the PCTFE film comprises PCTFE, at least one metal oxide selected from the group consisting of titanium oxide and zinc oxide and at least one fluororesin (exclusive of PCTFE) selected from the group consisting of ETFE and FEP species. The metal oxide is preferably zinc oxide. The fluororesin (exclusive of PCTFE) is preferably FEP. The fluororesin (exclusive of PCTFE) preferably amounts to 2 to 50% by mass relative to the total mass of the PCTFE and the fluororesin (exclusive of PCTFE). The content of the metal oxide is preferably 1.0 to 15.0% by mass.

As for the method of producing the PCTFE film according to the invention, the following may be mentioned, among others: The method comprising preparing a masterbatch by mixing up at least one fluororesin (exclusive of PCTFE) selected from the group consisting of CTFE and FEP species and a metal oxide, optionally together with PCTFE, then mixing up PCTFE and the masterbatch and molding the resulting mixture into a film; and The method comprising mixing up PCTFE, at least one metal oxide selected from the group consisting of titanium oxide and zinc oxide and at least one fluororesin (exclusive of PCTFE) selected from the group consisting of ETFE and FEP species and molding the resulting mixture into a film.

EFFECTS OF THE INVENTION

The PCTFE film according to the invention, which has the constitution described hereinabove, is excellent in ultraviolet shielding ability and moisture resistance and shows small absolute values of thermal deformation rates.

MODES FOR CARRYING OUT THE INVENTION

The following examples illustrate the present invention more specifically. These examples are, however, by no means limitative of the scope of the invention. The data given in each example and in each comparative example were obtained by the following methods of measurement.

1. Flow value

The sample resin is extruded through an orifice having a diameter of 1 mm and a length of 1 mm at a temperature of 230°C under a load of 100 kgf using a model CFT-500C flow tester (product of Shimadzu Corporation), and the volume of the resin extruded per second is measured.

2. UV shield rate

The transmittance (%) at the wavelength 360 nm is measured using a Hitachi model U-4100 spectrophotometer and the rate in question is calculated as follows:

```
Ultraviolet shield rate (%) = 100 - transmittance (%)
```

3. Water vapor transmission test

Measurements are made in accordance with JIS K 7129 (Method B) using PERMATRAN-W3/31 (product of MOCON, Inc.). As for the test conditions, the temperature is 40°C and the humidity is 90% RH.

4. Thermal deformation rate

Each cutout film sample, 50 mm x 50 mm in size, is allowed to stand in an electric oven maintained at 150°C for 30 minutes. The lengths in a direction of extrudate flow (machine direction; MD) and in a direction (transverse direction; TD) perpendicular to the direction of extrudate flow, respectively before and after heating, are measured. Then, the thermal deformation rate is calculated as follows;

```
Thermal deformation rate = {(length after heating) - (length
before heating)} ÷ (length before heating) x 100.
```

5. High-temperature high-humidity testing

Each sample laminate is allowed to stand in a constant-temperature constant-humidity vessel maintained at a temperature of 85°C and a humidity of 85% for 500 hours and, after taking out, the condition thereof is observed by the eye.

6. Initial peel strength

The peel strength of each sample laminate is measured on a Tensilon tensile tester (product of ORIENTED Co., Ltd.). The measurement conditions are as follows: peel rate: 25 mm/minute; peel angle: 180°.

7. Weathering test

Each sample laminate is subjected to 200 hours of ultraviolet irradiation at a panel temperature of 60°C using a SUPER UV accelerated testing apparatus (product of Iwasaki Electric Co., Ltd.) and then subjected to peel strength testing using a Tensilon tensile tester (product of ORIENTEC Co., Ltd.). The measurement conditions are as follows: peel rate: 25 mm/minute; peel angle: 180°.

8. Yellow index

Each sample specimen is measured for the difference in YI value (ΔYI value) from a white standard plate employed as a color standard using SM Color Computer model SM-7 (product of Suga Test Instruments Co. , Ltd.). A greater numerical value of ΔYI indicates that the yellowness is higher.

Example 1

A PCTFE powder (melting point: 212°C; flow value: 3.6 x $10^{-3}$ cc/sec) and acetylene black (Denka Black, product of Denki Kagaku Kogyo K.K.) were mixed up in a weight ratio of 90:10, and the mixed powder was fed to a 20 mm ∅twin-screw extruder (product of Toyo Seiki Seisaku-Sho, Ltd.) for melt kneading at 320°C; a masterbatch (MB) was thus prepared.

PCTFE natural pellets (Neoflon M-300PH, product of Daikin Industries, Ltd.) and the MB obtained as mentioned above were mixed up each in the form of pellets in a mixing ratio of 85/15 by weight, and the resulting mixture was extruded through a 50 mm ∅ T die extruder at a die temperature of 340°C to give a 25-μm-thick black PCTFE film. The film obtained was measured for the flow value, the UV shield rate, the water vapor transmission rate and the thermal deformation rates.

Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for the initial peel strength and then subjected to the high-temperature high-humidity test and the appearance of the PCTFE film was observed and, on the other hand, subjected to SUV irradiation in the manner of the weathering testing, followed by peel strength measurement.

Comparative Example 1

A laminate was produced by the same lamination procedure as in Example 1 and evaluated in the same manner except that a 25-μm-thick transparent PCTFE film was obtained from PCTFE natural pellets on the 50 mm ∅ T die extruder at a die temperature of 300°C without adding the ultraviolet absorber.

Comparative Example 2

An attempt was made to prepare a MB in the same manner as in Example 1 except that a benzophenone type ultraviolet absorber (UVINUL 3000, product of BASF AG) was used at an addition level of 5% in lieu of 10% of acetylene black. During molding, the PCTFE decomposed, colored brown and caused foaming, leading to failure to prepare the desired MB.

Comparative Example 3

An attempt was made to prepare a MB in the same manner as in Example 1 except that a benzotriazole type ultraviolet absorber (SEESORB 709, product of Shipro Kasei Kaisha, Ltd.) was used at an addition level of 5% in lieu of 10% of acetylene black. During molding, the PCTFE decomposed, colored brown and caused foaming, leading to failure to prepare the desired MB.

Comparative Example 4

An attempt was made to prepare a MB in the same manner as in Example 1 except that titanium oxide was used at an addition level of 10% in lieu of 10% of acetylene black. During molding, the PCTFE decomposed and caused foaming, leading to failure to prepare the desired MB.

Comparative Example 5

An attempt was made to prepare a MB in the same manner as in Example 1 except that zinc oxide was used at an addition level of 10% in lieu of 10% of acetylene black. During molding, the PCTFE decomposed and caused foaming, leading to failure to prepare the desired MB.

Comparative Example 6

A film was produced and evaluated in the same manner as in Example 1 except that the die temperature in the film forming step was 300°C.

Comparative Example 7

A film was produced and evaluated in the same manner as in Example 1 except that the die temperature in the film forming step was 320°C.

Example 2

A masterbatch (MB) was prepared by using an ethylene/tetrafluoroethylene copolymer (ETFE) powder (Neoflon ETFE EP-610, product of Daikin Industries, Ltd.) in lieu of the PCTFE powder, mixing up this powder and acetylene black (Denka Black, product of Denki Kagaku Kogyo K.K.) in a mixing ratio of 88:12 by weight, feeding the mixed powder to a 20 mm $\varnothing$ twin-screw extruder (product of Toyo Seiki Seisaku-Sho, Ltd.) for melt kneading at 300°C to give a masterbatch (MB). PCTFE natural pellets and the MB obtained in a pellet form were mixed up in a mixing ratio of 90/10 by weight, and the mixture was molded into a 25-$\mu$m-thick black PCTFE film on a 50 mm $\varnothing$ T-die extruder at a die temperature of 300°C. The film obtained was measured for the flow value, the UV shield rate, the water vapor transmission rate and the thermal deformation rates.
Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for the initial peel strength and then subjected to the high-temperature high-humidity test and the appearance of the PCTFE film was observed and, on the other hand, subjected to SUV irradiation in the manner of the weathering testing, followed by the peel strength measurement.

Example 3

Tetrafluoroethylene/hexafluoropropylene copolymer (FEP) (Neoflon FEP NP-20, DAIKIN Industries, Ltd.) powder was used in lieu of the PCTFE powder. The powder and acetylene black (Denka Black, product of Denki Kagaku Kogyo K.K.) were mixed up in a weight ratio of 85:15, and the mixed powder was fed to a 20 mm $\varnothing$ twin-screw extruder (product of Toyo Seiki Seisaku-Sho, Ltd.) for melt kneading at 360°C; a masterbatch (MB) was thus prepared.
PCTFE natural pellets and the MB obtained as mentioned above were mixed up each in the form of pellets in a mixing ratio of 90/10 by weight, and the resulting mixture was extruded through a 50 mm $\varnothing$ T die extruder at a die temperature of 300°C to give a 25-$\mu$m-thick black PCTFE film. The film obtained was measured for the flow value, the UV shield rate, the water vapor transmission rate and the thermal deformation rates.
Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 4

Ethylene/hexafluoropropylene copolymer (ETFE) (Neoflon ETFE EP-610, DAIKIN Industries, Ltd.) powder was used in lieu of the PCTFE powder. The powder and titanium oxide (FTR-700, product of Sakai Chemical Industry Co., Ltd.) were mixed up in a weight ratio of 70:30, and the mixed powder was fed to a 20 mm $\varnothing$ twin-screw extruder (product of Toyo Seiki Seisaku-Sho, Ltd.) for melt kneading at 300°C; a masterbatch (MB) was thus prepared. PCTFE natural pellets and the MB obtained as mentioned above were mixed up each in the form of pellets in a mixing ratio of 90/10 by weight, and the resulting mixture was extruded through a 50 mm ø T die extruder at a die temperature of 320°C to give

a 25-μm-thick white PCTFE film. The film obtained was measured for the UV shield rate, the water vapor transmission rate, the thermal deformation rates and the yellow index (ΔYI).

Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 5

The PCTFE powder, the FEP powder and titanium oxide were mixed up in a weight ratio of 35:35:30, and the mixed powder was fed to a 20 mm ø twin-screw extruder (product of Toyo Seiki Seisaku-Sho, Ltd.) for melt kneading at 300°C; a masterbatch (MB) was thus prepared. PCTFE natural pellets and the MB obtained as mentioned above were mixed up each in the form of pellets in a mixing ratio of 80/20 by weight, and the resulting mixture was extruded through a 50 mm ø T die extruder at a die temperature of 300°C to give a 25-μm-thick white PCTFE film. The film obtained was measured for UV shield rate, water vapor transmission rate, thermal deformation rates and yellow index (ΔYI).

Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 6

The PCTFE powder, the FEP powder and zinc oxide (product of Sakai Chemical Industry Co. , Ltd.; one species of zinc oxide, average particle diameter 0 . 8 μm) were mixed up in a weight ratio of 35:35:30, and the mixed powder was fed to a 20 mm ∅ twin-screw extruder (product of Toyo Seiki Seisaku-Sho, Ltd.) for melt kneading at 300°C; a masterbatch (MB) was thus prepared. PCTFE natural pellets and the MB obtained as mentioned above were mixed up each in the form of pellets in a mixing ratio of 80/20 by weight, and the resulting mixture was extruded through a 50 mm ∅ T die extruder at a die temperature of 310°C to give a 25-μm-thick white PCTFE film. The film obtained was measured for the UV shield rate, the water vapor transmission rate, the thermal deformation rates and the yellow index (ΔYI).

Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 7

The PCTFE powder, the FEP powder and zinc oxide (product of Sakai Chemical Industry Co. , Ltd. ; one species of zinc oxide, average particle diameter 0.8 μm) were mixed up in a weight ratio of 35:35:30, and the mixed powder was fed to a 20 mm ∅ twin-screw extruder (product of Toyo Seiki Seisaku-Sho, Ltd.) for melt kneading at 300°C; a masterbatch (MB) was thus prepared. PCTFE natural pellets and the MB obtained as mentioned above were mixed up each in the form of pellets in a mixing ratio of 70/30 by weight, and the resulting mixture was extruded through a 50 mm ∅ T die extruder at a die temperature of 310°C to give a 25-μm-thick white PCTFE films. The film obtained was measured for the UV shield rate, the water vapor transmission rate, the thermal deformation rates and the yellow index (ΔYI).

Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 8

The PCTFE powder, the ETFE powder and zinc oxide (product of Sakai Chemical Industry Co. , Ltd.; one species of zinc oxide, average particle diameter 0. 8 $\mu$m) were mixed up in a weight ratio of 70:30, and the mixed powder was fed to a 20 mm $\varnothing$ twin-screw extruder (product of Toyo Seiki Seisaku-Sho, Ltd.) for melt kneading at 300°C; a masterbatch, (MB) was thus prepared. PCTFE, natural pellets and the MB obtained as mentioned above were mixed up each in the form of pellets in a mixing ratio of 80/20 by weight, and the resulting mixture was extruded through a 50 mm $\varnothing$ T die extruder at a die temperature of 310°C to give a 25-$\mu$m-thick white PCTFE film. The film obtained was measured for the UV shield rate, the water vapor transmission rate, the thermal deformation rates and the yellow index ($\Delta$YI).
Further, one side of the film was subjected to corona discharge treatment and then to lamination treatment with a PET film (Lumilar, product of Toray Industries, Inc.), with the treated surface as an adhesive.surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement,

Example 9

The PCTFE powder, the ETFE powder and zinc oxide (product of Sakai Chemical Industry Co., Ltd.; micropowder type of one species of zinc oxide, average particle diameter 0.3 $\mu$m) were mixed up in a weight ratio of 35:35:30, and the mixed powder was fed to a 20 mm $\varnothing$ twin-screw extruder (product of Toyo Seiki Seisaku-Sho, Ltd.) for melt kneading at 300°C; a masterbatch (MB) was thus prepared. PCTFE natural pellets and the MB obtained as mentioned above were mixed up each in the form of pellets in a mixing ratio of 70/30 by weight, and the resulting mixture was extruded through a 50 mm ø T die extruder at a die temperature of 310°C to give a 25-$\mu$m-thick white PCTFE film. The film obtained was measured for the UV shield rate, the water vapor transmission rate, the thermal deformation rates and the yellow index ($\Delta$YI).
Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 10

The PCTFE powder, the ETFE powder and zinc oxide (product of Sakai Chemical Industry Co., Ltd.; average particle diameter 0.8 $\mu$m were mixed up in a weight ratio of 81:10: 9, and the mixed powder was fed to a 20 mm ø twin-screw extruder (product of Toyo Seiki Seisaku-Sho, Ltd.) and melt-kneaded at 300°C to give premix pellets. The premix pellets obtained were extruded through a 50 mm ø T die extruder at a die temperature of 300°C to give a 25-$\mu$m-thick white PCTEE film. The film obtained was measured for the UV shield rate, the water vapor transmission rate, the thermal deformation rates and the yellow index ($\Delta$Y1).
Further, one side of the film was subjected to corona discharge treatment and then to lamination treatment with a PET film (Lumilar, product of Toray Industries, Inc.), with the treated surface as an adhesive surface, via an adhesive (Hibon YA211; product of Hitachi Kasei Polymer Co., Ltd.) to give a laminate. This laminate was measured for initial peel strength and then subjected to the high-temperature high-humidity test and the appearance of the PCTFE film was observed and, on the other hand, subjected to SUV irradiation in the manner of the weathering testing, followed by the peel strength measurement.

Example 11

A PCTFE film and a laminate were produced in the same manner as in Example 10 except that the thickness of the PCTFE film was adjusted to 18 $\mu$m. The film and laminate was subjected to physical characteristics evaluation.

Example 12

A PCTFE film and a laminate were produced in the same manner as in Example 10 except that the thickness of the PCTFE film was adjusted to 50 $\mu$m. The film and laminate was subjected to physical characteristics evaluation.

The results of various measurements of the MBs, films and laminates obtained in Examples 1 to 12 and Comparative Examples 1 to 7 are shown in Tables 1 and 2.

[Table 1]

| | | Comp Ex 1 | Comp. Ex. 2 | Comp. Ex. 3 | Comp. Ex. 4 | Comp. Ex. 5 | Example 1 | Comp. Ex. 6 | Comp. Ex. 7 | Example 2 | Example 3 |
|---|---|---|---|---|---|---|---|---|---|---|---|
| MB | Base resin | - | PCTFE | PCTFE | PCTFE | PCTFE | PCTFE | PCTFE | PCTFE | ETFE | FEP |
| | UVA species | - | benzophenone | benzotriazole | titanium oxide | zinc oxide | CB | CB | CB | CB | CB |
| | UVA addition level (wt%) | - | 5 | 5 | 10 | 10 | 10 | 10 | 10 | 12 | 15 |
| | MB molding | - | not possible (decomposed) | not possible (decomposed) | not possible (decomposed) | not possible (decomposed) | possible | possible | possible | possible | possible |
| Film | Color | transparence | - | - | - | - | black | black | black | black | black |
| | PCTFE/MB mixing ratio | 0 | - | - | - | - | 85115 | 85115 | 85/15 | 90/10 | 90/10 |
| | Amount of UVA (wt%) | 0 | - | - | - | - | 1.5 | 1.5 | 1.5 | 1.2 | 1.5 |
| | Die temperature (°C) | 300 | - | - | - | - | 340 | 300 | 320 | 300 | 300 |
| | Flow value (x10$^{-3}$cc/sec) | 48 | - | - | - | - | 345 | 60 | 176 | 33 | 50 |
| | UV cut-off percentage (%) | 6.9 | - | - | - | - | 99.9 | 99.9 | 99.9 | 99.8 | 99.9 |
| | Water vapor permeation rate (g/m$^2$·day) | 0.23 | - | - | - | - | 0.20 | 0.18 | 0.22 | 0.22 | 0.24 |
| | Thermal deformation percentage MD (%) | 4.6 | - | - | - | - | -1.0 | 5.3 | 4.5 | -1.9 | 0.1 |

EP 2 284 213 A1

(continued)

| | | Comp Ex 1 | Comp. Ex. 2 | Comp. Ex. 3 | Comp. Ex. 4 | Comp. Ex. 5 | Example 1 | Comp. Ex. 6 | Comp. Ex. 7 | Example 2 | Example 3 |
|---|---|---|---|---|---|---|---|---|---|---|---|
| | Thermal deformation percentage TD (%) | -5.6 | - | - | - | - | -0.9 | -6.7 | -5.9 | 1.2 | 1.1 |
| Laminate | Initial peel strength (N/15mm) | 5 | - | - | - | - | 4.3 | - | - | 5.0 | 4.8 |
| | High-temperature high-humidity testing occurring (outward appearance) | crack | - | - | - | - | no problem | crack occurring | crack occurring | no problem | no problem |
| | Weathering test (N/15mm) | 0 | - | - | - | - | 4.9 | - | - | 4.9 | 4.6 |

The data shown in Table 1 indicate that carbon black is the only ultraviolet absorber that can be directly added to PCTFE. It was also found that lower molding temperatures for black PCTFE films with carbon black added result in greater absolute values of thermal deformation rates, whereas higher molding temperatures can result in lower absolute values. Further, by using ETFE or FEP as the masterbatch resin, it has become possible to reduce the thermal deformation rates to levels not higher than 2% even at relatively low film molding temperatures. Even when PCTFE was admixed with an amount of 10% of the masterbatch comprising another resin, the water vapor transmission rate did not change; hence good moisture resistance could be exhibited. The laminates derived from the PCTFE, films showing absolute values of thermal deformation rates of not lower than 5% underwent cracking under high-temperature high-humidity circumstances; when the absolute values in question are not higher than 5%, however, good appearances were maintained. The laminates comprising a PCTFE film provided with the ultraviolet shielding function retain their good peel strength even after ultraviolet irradiation and, therefore, can be regarded as laminates excellent in weathering resistance.
[Table 2]

| | | Example 4 | Example 5 | Example 6 | Example 7 | Example 8 | Example 9 | Example 10 | Example 11 | Example 12 |
|---|---|---|---|---|---|---|---|---|---|---|
| MB | Base resin (wt%) | | | | | | | | | |
| | PCTFE | - | 35 | 35 | 35 | 35 | 35 | | | |
| | ETFE | 70 | - | - | - | 35 | 35 | | | |
| | FEP | - | 35 | 35 | 35 | - | - | - | - | - |
| | UVA species | Titanium oxide | titanium oxide | Zinc oxide | Zinc oxide | Zinc oxide | Zinc oxide (micropowder) | | | |
| | UVA addition level (wt%) | 30 | 30 | 30 | 30 | 30 | 30 | | | |
| | MB molding | possible | possible | possible | possible | possible | possible | | | |
| Film | Color | White | White | White | White | White | White | White | White | White |
| | Thickness (mm) | 25 | 25 | 25 | 25 | 25 | 25 | 25 | 18 | 50 |
| | PCTFE/MB mixing ratio | 90/10 | 80/20 | 80/20 | 70/30 | 70/30 | 70/30 | - | - | - |
| | Resin other than PCTFE | ETFE | FEP | FEP | FEP | ETFE | ETFE | ETFE | ETFE | ETFE |
| | UVA species | Titanium oxide | Titanium oxide | Zinc oxide | Zinc oxide | Zinc oxide | Zinc oxide (micropowder) | Zinc oxide | Zinc oxide | Zinc oxide |
| | Amount of UVA (wt%) | 3,0 | 6.0 | 6.0 | 9.0 | 9.0 | 9.0 | 9.0 | 9.0 | 9.0 |
| | Die temperature (°C) | 320 | 300 | 310 | 310 | 310 | 310 | 300 | 300 | 300 |
| | Yellow index ($\Delta$YI) | 11.02 | -1.92 | -0.41 | -0,78 | 2.65 | 8.08 | 2.80 | 2.80 | 2.80 |
| | Outward appearance | good | foaming | good | good | good | foaming | good | good | good |
| | Flow value ($\times 10^{-3}$cc/sec) | 88.1 | 38 | 37.2 | 21.7 | 81.2 | 60.1 | 72.7 | 68.9 | 89.7 |
| | UV cut-off percentage (%) | 98.6 | 99.9 | 98 | 99.6 | 99.5 | 99.9 | 99.8 | 97.6 | 99.9 |

|  |  | Example 4 | Example 5 | Example 6 | Example 7 | Example 8 | Example 9 | Example 10 | Example 11 | Example 12 |
|---|---|---|---|---|---|---|---|---|---|---|
|  | Water vapor permeation rate (g/m$^2$·day) | 0.35 | 0.40 | 0.18 | 0.40 | 0.26 | 0.10 | 0.33 | 0.44 | 0.19 |
|  | Thermal deformation percentage MD (%) | -1.99 | -1.68 | -1.59 | -1.26 | 0,07 | -1.67 | -1.62 | -1.88 | -0.98 |
|  | Thermal deformation percentage TD (%) | -0.4 | 0.24 | -0.21 | -0.01 | -1.68 | -0.59 | -0.53 | -0.87 | -0.12 |
| Laminate | Initial peel strength (N/15mm) | 5.1 | - | 5.2 | 4.9 | 4.3 | - | 5.3 | 4.5 | 6.0 |
|  | High-temperature high-humidity testing (outward appearance) | No problem | No problem | No problem | No problem | No problem | No problem | No problem | No problem | No problem |
|  | Weathering test (N/15mm) | 5.3 | - | 4.9 | 5.0 | 4.9 | - | 5.0 | 4.4 | 6.6 |

The data shown in Table 2 indicate that the combined use of PCTFE and the fluororesin other than PCTFE makes it possible to obtain titanium oxide- or zinc oxide-containing PCTFE films. As is evident from Example 6, relatively high levels of addition of zinc oxide do not cause poor appearances. In Examples 5 to 7, in which the fluororesin other than PCTFE was FEP, only low levels of discoloration were observed. In Example 9, in which ETFE was included and the average particle diameter of zinc oxide was small, a poor appearance was observed. The films of Examples 6 and 7, namely the films comprising PCTFE, FEP and zinc oxide, have very good characteristics.

INDUSTRIAL APPLICABILITY

The PCTFE film according to the invention can be utilized as a backsheet for a solar cell module.

**Claims**

1. A polychlorotrifluoroethylene film having an ultraviolet shield rate of not lower than 70%, a water vapor transmission rate of not higher than 1.00 g/m$^2$·day and absolute values of thermal deformation rates after 30 minutes-heating at 150°C of not higher than 5.0%.

2. The polychlorotrifluoroethylene film according to Claim 1, wherein the ultraviolet shield rate is not lower than 95.0%.

3. The polychlorotrifluoroethylene film according to Claim 1 or 2, wherein the water vapor transmission rate is not higher than 0.50 g/m$^2$·day.

4. The polychlorotrifluoroethylene film according to Claim 1, 2 or 3, wherein the absolute values of thermal deformation rates are not higher than 2.0%.

5. A laminate comprising the polychlorotrifluoroethylene film according to Claim 1, 2, 3 or 4 and a resin sheet other than said polychlorotrifluoroethylene film.

6. A backsheet for a solar cell module comprising the polychlorotrifluoroethylene film according to Claim 1, 2, 3 or 4 or the laminate according to Claim 5.

## INTERNATIONAL SEARCH REPORT

| International application No. |
| --- |
| PCT/JP2009/059329 |

| A. CLASSIFICATION OF SUBJECT MATTER |
| --- |
| *C08J5/18*(2006.01)i, *B32B27/30*(2006.01)i, *H01L31/04*(2006.01)i |

According to International Patent Classification (IPC) or to both national classification and IPC

| B. FIELDS SEARCHED |
| --- |
| Minimum documentation searched (classification system followed by classification symbols) |
| C08J5/18, B32B27/00-27/42, C08L27/00-27/24, C08K3/00-13/08 |

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

| C. DOCUMENTS CONSIDERED TO BE RELEVANT |

| Category* | Citation of document, with indication, where appropriate, of the relevant passages | Relevant to claim No. |
| --- | --- | --- |
| X<br>Y | JP 2001-127320 A (Toppan Printing Co., Ltd.),<br>11 May, 2001 (11.05.01),<br>Claims; Par. Nos. [0015], [0018]; examples<br>(Family: none) | 1-6<br>1-6 |
| Y | JP 10-195269 A (Asahi Glass Co., Ltd.),<br>28 July, 1998 (28.07.98),<br>Claims<br>(Family: none) | 1-6 |
| Y | JP 9-137026 A (Daikin Industries, Ltd.),<br>27 May, 1997 (27.05.97),<br>Claims; Par. Nos. [0006], [0012]<br>(Family: none) | 1-6 |

☐ Further documents are listed in the continuation of Box C. ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>17 July, 2009 (17.07.09) | Date of mailing of the international search report<br>28 July, 2009 (28.07.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001127320 A
- US 4663230 A

- JP H03174018 B